Europäisches Patentamt

European Patent Office

Office européen des brevets

(11) Publication number: **0 572 940 A2**

# EUROPEAN PATENT APPLICATION

(21) Application number: **93108656.5**

(22) Date of filing: **28.05.93**

(51) Int. Cl.⁵: **G01R 31/28**

(30) Priority: **29.05.92 IT TO920457**

(43) Date of publication of application:
**08.12.93 Bulletin 93/49**

(84) Designated Contracting States:
**DE ES FR GB**

(71) Applicant: **MERLONI ELETTRODOMESTICI S.p.A.**
**Viale Aristide Merloni, 45**
**I-60044 Fabriano (AN)(IT)**

(72) Inventor: **Fontanella, Andrea**
**Vico S. Eframo Vecchio 55**
**I-Napoli(IT)**

(54) **Automatic functional test system for household electrical appliances.**

(57) An automatic functional test system for electrical household appliances is described, in particular refrigerators, the principle characteristic of the system is that it allows for the carrying out of automatic tests on appliances, through the comparison of functional parameters of the appliances in thermostatic running cycle, with reference parameters obtained experimentally from prototypes of appliances to be tested, inserted in a time and environmental temperature function algorithm.

FIG. 3

EP 0 572 940 A2

The present invention refers to an automatic functional test system for electrical household appliances, in particular refrigerators.

As known the testing of electric appliances is traditionally carried out manually by one or more testers based on their experience and on test specifications prepared by suitable institutional establishments (design, quality control service, etc.) for judging the acceptability or not of the product.

Such type of test unavoidably involves an important subjective involvement, particularly concerning the characteristics which are not easily measurable with exactness during the course of the test, such as running temperatures reached, cycle times, etc. Furthermore such characteristics are usually measured only on a reduced percentage of appliances, as it is not easy to carry out such measures on every piece, for obvious reasons.

It would obviously be desirable, in order to ensure a constant quality of the product, to carry out a test on the entire production, so as to also control such important functional aspects, possibly in an objective manner.

The aim of the present invention is that of overcoming the drawbacks of the prior art and in particular to indicate an automatic functional test system for electrical household appliances, in particular refrigerators, that allows to measure and assess all the necessary characteristics of the entire production for ensuring a constant quality of the product, with accessible costs.

Such aim is reached according to the present invention by way of an automatic functional test system for electrical household appliances, in particular refrigerators, characterised in that it allows for the carrying out of automatic tests on appliances, through the comparison of functional parameters of the appliances in thermostatic running cycle, with reference parameters obtained experimentally from prototypes of appliances to be tested, inserted in a time and environmental temperature function algorithm.

Further characteristics and advantages of the present invention will result in being clear from the description that follows and from the annexed drawings, supplied purely as an explanatory and non-limiting example, wherein:

figure 1 schematically represents an example of a possible layout of the functional test zone according to the invention;
figure 2 schematically represents an example of the given acquisition system for the test according to figure 1;
figure 3 represents an example of the temperature/time curve during the test;
figure 4 represents an example of the absorbtion/time curve during the test.

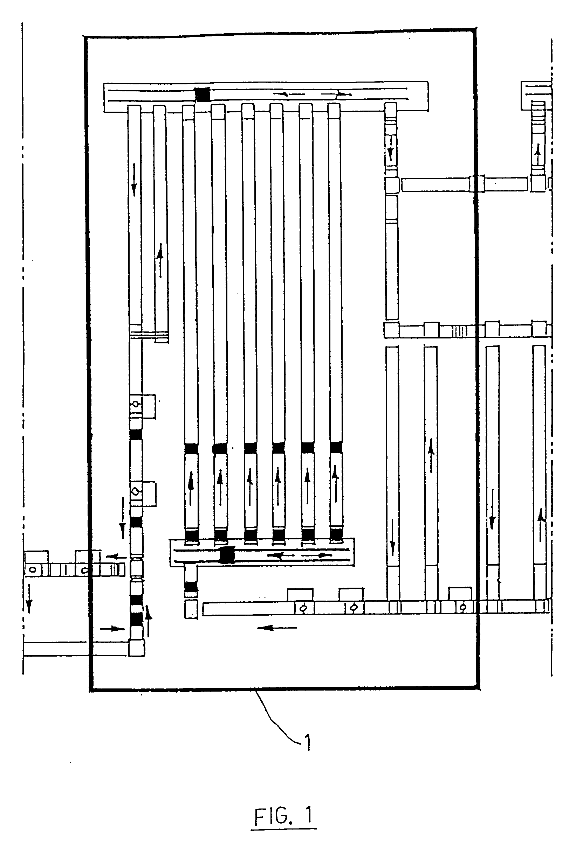

With regards the mentioned figures, reference number 1 indicates the functional test zone (fig. 1); the example that will now be described in detail refers to the test case of refrigerator appliances.

The same test system may be noticeably applied, "mutatis mutandis", with other electric appliances, such as for example washing-machines or dish-washing machines.

As can be seen in figure 1, the test area is composed of six rolling lines each being of the capacity of thirty appliances; with each stage of the roller, about 80 cm, an acquisition module of test parameters is arranged, in connection with each appliance to be tested.

Each of the 180 acquisition modules is composed of:

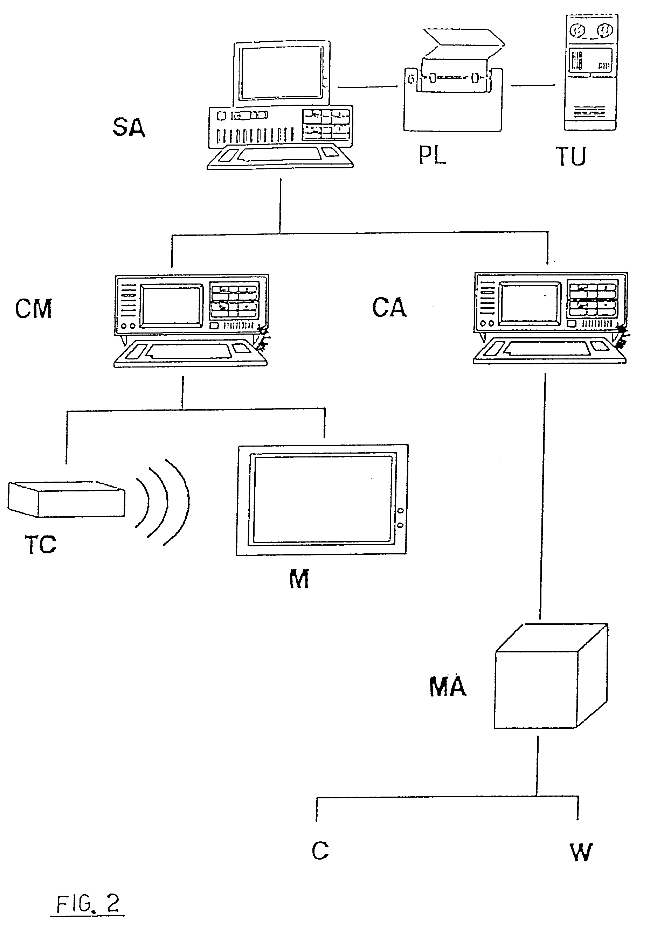

- an interface card for two thermocouples (C, fig. 2) that serve to detect the temperatures of the refrigerator cell and of the freezer cell;
- an interface card for a watt-meter (W, fig. 2) for the acquisition of the power utilised;
- an analogical multiplexer;
- an analogical signals transmitter;
- compensated copper-costantan socket (of the type PAN-33302-TX by the firm Thermo Electric) for the connection of the aforementioned thermocouples;
- socket for the electrical supply.

The thirty acquisition modules (MA, fig. 2), of each of the six test lines, are connected by means of a shielded cable to a line controller (CA), constituted by an industrial computer; which provides for acquiring the data, from each module, with a frequency of thirty seconds for temperature and of five seconds for the power.

The six line controllers are connected to an area supervisor (SA, fig. 2), whose characteristics are:

- IBM PS2/95;
- Architecture Micro-channel;
- Processor 80486, 25 MHz, 8 Mbyte of central memory, 320 Mbyte of hard disk ESDI, coloured video VGA.

To the area supervisor the following are connected (fig. 2):

- a personal computer defined "monitor controller" (CM), that pilots a monitor (M) with a 46" screen for the display of the graphic output, in the direction of the test operators, of the performance curves and of the synoptic data for the monitorisation of the test area; the monitor can be controlled by means of a remote-control device (TC);
- a laser printer (PL) for the data print;
- a tape registration unit (TU) for recording data.

The area supervisor (SA) utilises a suitable software that has the following aspects:

- operative system: UNIX System V 3.2 in the version released by the company Santa Cruz Operation (S.C.O.);
- graphic software: OSF/motiv, operating on X window, as before in the version S.C.O;
- DBMS: unformix RDS is utilised, relational data bases on the SQL base, released by Informix Inc.

The products to be tested are divided into functional families, function of the volumetric capacity of products and of the power of compressors that equip them.

The functional family is communicated to the area supervisor by means of bar code reading, and allows the supervisor to carry out the comparison of acquired parameters with those of reference; the latter are:

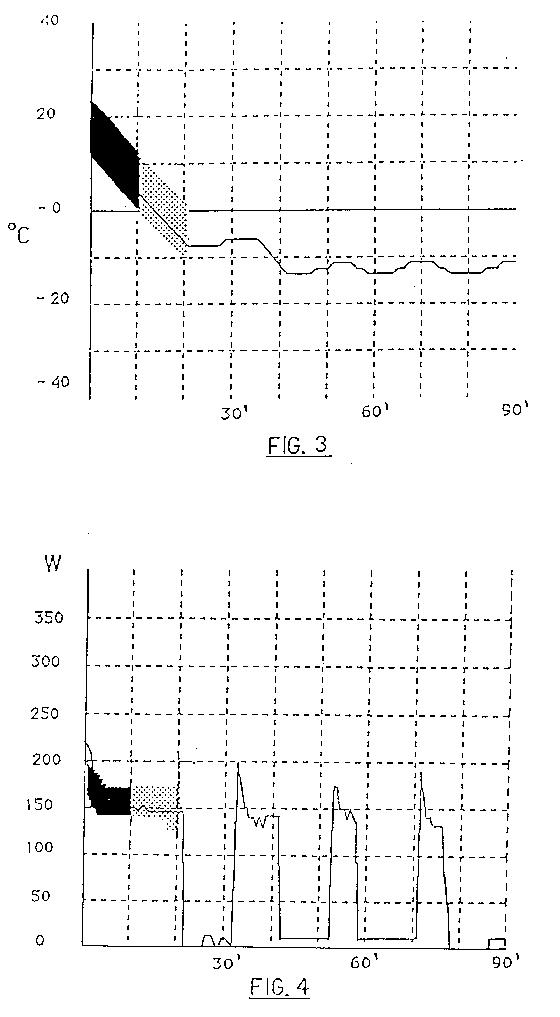

- refrigerator and freezer temperature values reached upon termination of the test ;
- curve of initial temperature descent (pull-down curve) and of absorbtion, after the starting of the compressor (see for e.g. fig. 3);
- times/temperature of disconnecting/reconnecting the thermostat (see for e.g. fig. 4);
- duty-cycle.

All values are compared to those of reference within the presettable field values for each functional family; reference values are obtained experimentally from prototypes of products to be tested and are gradually recalculated based on the measured values during the test on the products judged positive by the automatic system (and judged positive by a manual test operator).

For this a suitable algorithm is utilised. During the test period, established for the last piece taken on each test line of 90 minutes, the system confronts the real curves (constructed for linear interpolation of detected points or, if possible, as an envelope of the line thus obtained) of temperatures of the refrigerator and freezer compartments with the theoretic reference curves obtained with the algorithm:

$$Tt = (C1 + C2 \times Ta) + (C3 + C4 \times Ta)xt$$

where:
Tt = theoretic temperature to the time t and at environment temperature Ta;
Ta = temperature environment;
t = time of functioning;
C1, C2, C3, C4 = coefficients of the line delimited from the functioning time, which approaches the theoretic curve.

The power used is compared with functional reference values of the environmental temperature and of the functioning time, using a similar algorithm to that of the temperatures:

$$Pt = (c1 + c2 \times Ta) + (c3 + c4 \times Ta)xt$$

where:
Pt = theoretic power to the time t and to the environmental temperature Ta;
Ta = environment temperature;
t = time of functioning;
C1, C2, C3, C4 = coefficients of the line delimited from the functioning time, that approaches the theoretic curve.

All within pre-determinable functioning fields and being however asymmetric if compared to the average value.

Each judgement parameter of a functional family may be modified by the operator.

The system can function in two ways:
manual (the system acquires data, but waits for the confirmation of the operator for judging the product);
automatic (the system acquires data, compares with reference values, judges the product and directs it automatically towards the packaging or in the direction of the repairs).

In the Figures 3 and 4 the first part of the curves is represented with a strip being more or less dark; such strip, that can be set for each functional family, representing the black out time within which only the acquisition of data is desired but not to test.

At the end of the black out time the judgement is carried out in real-time and therefore the apparatus could be discarded even before the deadline of the established time for the test or if possible repaired and recovered before such deadline.

From the present description the characteristics of the automatic test system subject of the present invention are clear, as are clear its advantages.

In particular they are represented in the fact that:

- the analysis of the functional behaviour of the whole product is carried out and furthermore in thermostatic running cycle;
- an objective judgement is made possible respect the comparison parameters;
- it constitutes an "expert system" inasmuch all the products judged to be positive in the test and judged positive by the operator in the manual test go on to make up a historical data base that allows, for each functional family, to recalculate reference parameters;
- real-time interaction with the operator on the proceedings of the test at every single station;
- monitoring the state of the acquisition instruments (thermocouples, watt-meters); such monitoring is carried out analysing the value of measures acquired; the "overflow" indicates the poor functioning of the instrument. This is signalled in a synoptic manner.

It is clear that numerous variations can be introduced to the automatic test system described as an example, without departing from the novelty principles inherent in the innovative idea, as is clear that in a practical realisation of the idea the materials and the forms of the illustrated details may be different, and they can be replaced with technically equivalent elements.

For example the acquisition modules MA could be connected to the line controller CA via radio, thus allowing the advancement along the line of apparatuses and of the data acquisition modules during the test phase.

## Claims

1. Automatic functional test system for electrical household appliances, in particular refrigerators, characterised in that it allows for the carrying out of automatic tests on appliances, through the comparison of functional parameters of the appliances in thermostatic running cycle, with reference parameters obtained experimentally from prototypes of appliances to be tested, inserted in a time and environmental temperature function algorithm.

2. Automatic functional test system, according to claim 1, characterised in that according to said algorithm, during the test period (90 minutes), the system confronts the curves constructed for linear interpolation of detected points or as an envelope of the line thus obtained, of the temperatures of the refrigerator and freezer compartments and of the power utilised, with theoretic reference curves, obtained as linear functions of time and of the environmental temperature, within predeterminable functioning fields and being asymmetric compared to the average value.

3. Automatic functional test system, according to claim 1 or 2, characterised in that it comprises a plurality of data detection modules (MA), that transmit the data detected, in real-time, to a computerised system (CA, SA, CM) for acquiring and assessing the actual data, that comprises in particular an acquisition controller (CA) for each group of detection modules (MA) and an area supervisor (SA) for each group of controllers (CA).

4. Automatic functional test system, according to claim 3, characterised in that said area supervisor (SA) controls at least one accessory device (CM, M; PL; TU), in particular a printer (PL), and/or a data registration device (TU), and/or a display device (M).

5. Automatic functional test system, according to claim 3, characterised in that each of said detection modules (MA), comprises at least one interface card for data detection devices, an analogical multiplexer for multiplexing the detected data, an analogic signals transmitter.

6. Automatic functional test system, according to claim 5, characterised in that said interface card is an interface card for thermocouples for temperature detection or for a watt-meter for detection of the electric power absorbed.

7. Automatic functional test system, according to claim 3, characterised in that said area supervisor (SA) makes a comparison between the detected data and the reference parameters obtained experimentally from prototypes of apparatuses to be tested and in particular provides for making up a historic data base with all the parameters relative to products judged positive during the test, and that based on said data base said comparison parameters are periodically recalculated.

8. Automatic functional test system, according to claim 1 or 2, characterised in that it can function in two ways: a manual first way wherein the system acquires data, but awaits confirmation of the operator for judging the product, and a second automatic way wherein the system acquires data, confronts it with reference values, judges the product and directs it automatically towards packaging or repair.

9. Automatic test system for refrigerators, according to claim 1 or 2, characterised in that said reference parameters include refrigerator and freezer temperature values reached upon termination of the test, and/or curve values of initial temperature descent and of the electric energy absorbtion, and/or time and temperature values of disconnecting and reconnecting the thermostat, and/or of duty-cycle values.

10. Automatic test system for refrigerators, according to claim 3, characterised in that said data detect modules (MA) transmit detected data to the computerised system (CA, SA, CM) through a shielded cable.

11. Automatic test system for refrigerators, according to claim 3, characterised in that said data detect modules (MA) transmit detected data to the computerised system (CA, SA, CM) via radio.

12. Automatic test system for refrigerators, according to one or more of the previous claims, characterised in that at the beginning of the test the data is not utilised for the aims of testing the apparatus.

FIG. 1

FIG. 2

FIG. 3

FIG. 4

8